Europäisches Patentamt

European Patent Office

Office européen des brevets

(19)

(11) **EP 0 929 154 A1**

(12) **EUROPEAN PATENT APPLICATION**

(43) Date of publication:
**14.07.1999 Bulletin 1999/28**

(51) Int Cl.⁶: **H03K 19/096, H03K 19/017**

(21) Application number: **99300118.9**

(22) Date of filing: **07.01.1999**

| | |
|---|---|
| (84) Designated Contracting States:<br>**AT BE CH CY DE DK ES FI FR GB GR IE IT LI LU MC NL PT SE**<br>Designated Extension States:<br>**AL LT LV MK RO SI** | (72) Inventor: **Naffziger, Samuel D.**<br>**Fort Collins, CO 80525 (US)** |
| (30) Priority: **12.01.1998 US 5886** | (74) Representative: **Colgan, Stephen James et al**<br>**CARPMAELS & RANSFORD**<br>**43 Bloomsbury Square**<br>**London WC1A 2RA (GB)** |
| (71) Applicant: **Hewlett-Packard Company**<br>**Palo Alto, California 94304 (US)** | |

(54) **Annihilation based logic gates for high fanin functions**

(57)     An annihlation based logic gate (500) which evaluates the complementary sense of a high fanin ANDing function (i.e., an OR function). First (506) and second (508) nodes are precharged (502, 504) during a precharge phase of the clock. During an evaluate phase of the clock, discharge (510) of the first node is begun substantially simultaneously with evaluation of the complementary OR function. If the complementary OR function evaluates true, the second node is pulled down so as to cancel discharge of the first node. The circuit may be timed so that evaluation of the complementary OR function occurs just prior to the first node's being discharged beyond a trigger point of an output inverter (518). The output (520) thus transitions in a monotonic fashion.

FIG. 5

## Description

### Field of the Invention

The following description pertains to the field of dynamic logic gates, and more particularly, to a system and method for utilizing annihilation based logic gates. Annihilation based logic gates allow high fanin functions to be implemented with less delay.

### Background of the Invention

"Dynamic" logic gates are known in the art. Dynamic logic gates are used in the conventional design of logic circuits which require high performance and modest size. Dynamic logic gates are much faster than static logic gates and have lower input capacitance. However, dynamic logic gates require a periodic electrical precharge, or refresh, in order to maintain and properly perform their intended function. Once an electrical precharge supplied to a dynamic logic gate has been discharged by the dynamic logic gate, the dynamic logic gate can no longer evaluate another logic function until it is subsequently precharged.

Dynamic logic gates are used in many applications. Oftentimes, as for example in cache addressing, a logic function to be evaluated has many inputs (i.e., a "high fanin"). For example, a 128 block cache addressable one block at a time requires a 7-bit address. An address decoder associated with the 128 block cache may accordingly require a 7-bit AND gate or a 7-bit comparator. Due to recent technology advances, address busses are typically even wider than 7 bits (e.g., 32, 64, or even 128 bits).

One very useful feature of a dynamic logic gate is the monotonic nature of its signaling. That is, signals only transition in one direction during the evaluate period (i.e., from low to high, or from high to low). In order to maintain this monotonic signaling, one must compute the true "AND" sense for decodes and compares. Even though the complementary sense of a decode or compare can be computed utilizing a much faster OR function, the results of these complementary functions are not as useful.

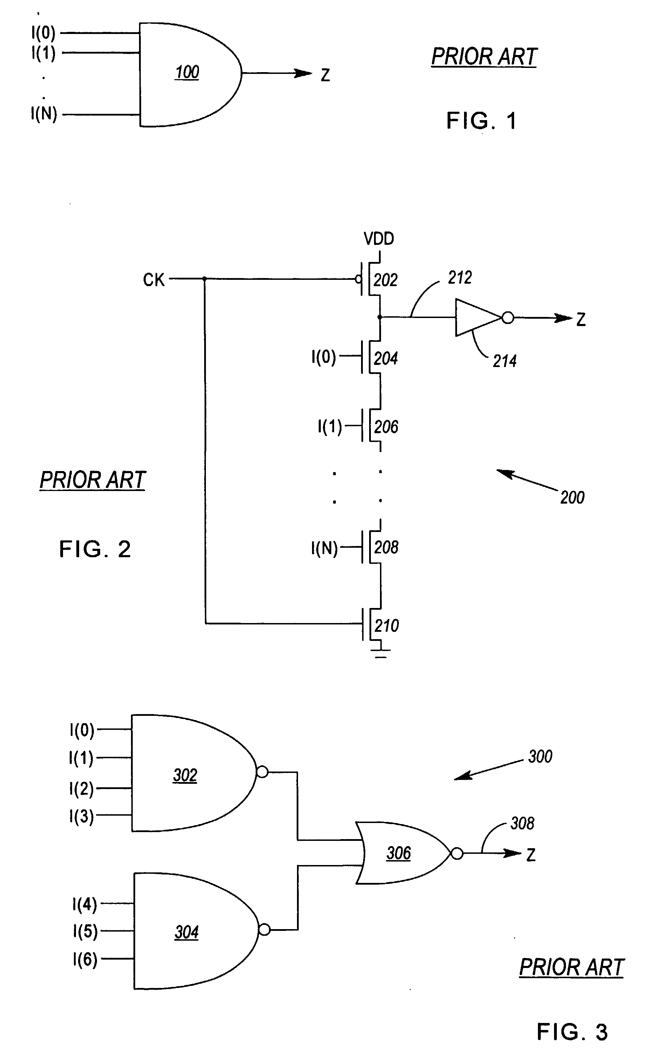

FIG. 1 is a logic diagram of an N-input AND gate 100. In a basic prior art implementation, as illustrated in FIG. 2, an N-bit dynamic AND gate 200 comprises a stack of NFETS 204-208 (n-channel field effect transistors) connected between a precharged line 212 and ground. The precharged line is pulled high during a precharge phase by a PFET 202 (p-channel FET) connected between the precharged line 212 and a voltage source (VDD is used as a voltage source throughout the drawings). Each FET 204-208 in the stack is coupled to receive a different one of N inputs (I(0), I(1). . .I(N)). As a result, the precharged line 212 will be pulled low, and the output Z will be asserted, only when the gate signal of each NFET 204-210 is high (true). For a high fanin AND gate (i.e., a single AND gate 200 with a large number of inputs), the number of stacked FETS 204-208 becomes proportionally large. The larger the number of inputs, the more time it takes to pull the precharged line 212 low.

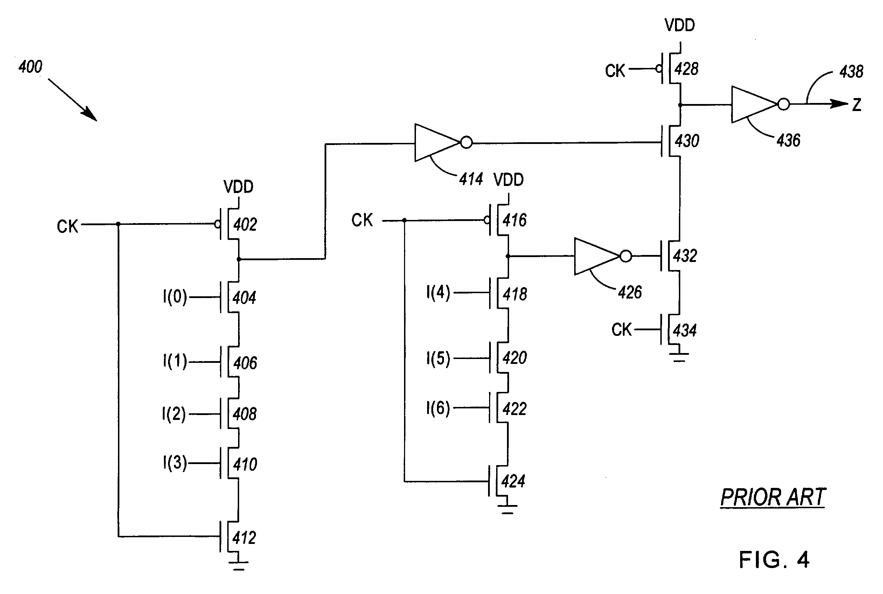

Accordingly, high fanin AND gates are often implemented using several less-than-N input pulldown trees 404-410, 418-422 connected in parallel, which in turn feed a second tier pulldown tree 430, 432, which in turn feeds an inverter 436. FIGS. 3 and 4 illustrate an example of such an alternative implementation of a prior art 7-bit AND gate 300, 400. FIG. 3 is a logic diagram of the 7-bit AND gate 300, which shows the 7 inputs (I(0)..I(6)) divided into two groups. Inputs I(0)..I(3) are fed into a 4-bit NAND gate 302, and inputs I(4)..I(6) are fed into a 3-bit NAND gate 304. The outputs of the 4-bit NAND gate 302 and the 3-bit NAND gate 304 are evaluated in parallel and then fed into a NOR gate 306 to produce an output signal Z 308 indicative of a logical AND of inputs I(0)..I(6). FIG. 4 shows a typical prior art CMOS implementation 400 of the 7-bit AND gate 300 of FIG. 3. The implementation comprises first 404-410, second 418-422, and third 430, 432 pulldown trees. Associated with each pulldown tree is a precharger 402, 416, 428 and an inverter 414, 426, 436, as is customary in the art. Each pulldown tree may further comprise a series connected switch 412, 424, 434 for alternately activating and deactivating the tree. However, even though the number of FETS in each pulldown tree is less than the number of FETS in the single pulldown tree of FIG. 2, even this alternative prior art implementation of a dynamic AND gate can be slow to evaluate.

High fanin comparators, which evaluate whether two or more values are equivalent, and which are generally implemented with a logical exclusive-NOR (XNOR) function, suffer from similar speed limitations. Accordingly, it would be desirable to provide a method and apparatus for evaluating high fanin logical AND and comparator functions at high speeds.

### Summary of the Invention

The present invention therefore provides for 1) evaluating the complementary sense of a high fanin function (e.g., the complementary sense of an AND or comparator function), and then 2) converting the output of the complementary function (e.g., an OR function) to its monotonic AND equivalent. As a result, high fanin functions of any type may be evaluated at high speeds (since OR functions may be evaluated much faster than AND functions).

The invention may be implemented as either an edge-triggered or self-timed logic gate. In either embodiment, high fanin logical AND and comparator functions may be evaluated much faster than in prior art implementations. This is accomplished by precharging first and second nodes during the precharge phase of a clock. During an evaluate phase of the clock, discharge of the first node is begun substantially simultaneously with evaluation of the complementary OR function. If the complementary OR function evaluates true, the second node is pulled down so as to cancel discharge of the first node. The circuit may be timed so that evaluation of the complementary OR function occurs just prior to the first node's being discharged beyond a trigger point of an output inverter to which it is connected. The monotonic nature of the output is thus maintained.

These and other important advantages and objectives of the present invention will be further explained in, or will become apparent from, the accompanying description, drawings and claims.

**Brief Descriptions of the Drawings**

An illustrative and presently preferred embodiment of the invention is illustrated in the drawings in which:

FIG. 1 is a gate level schematic of a prior art N-bit logical AND gate.
FIG. 2 is a FET level schematic of a dynamic CMOS logic implementation of the FIG. 1 N-bit AND gate;
FIG. 3 is a gate level schematic of an alternative prior art N-bit logical AND gate (wherein N=7);
FIG. 4 is a FET level schematic of a dynamic CMOS logic implementation of the FIG. 3 N-bit logical AND gate;
FIG. 5 is a block diagram of an edge-triggered annihilation based logic gate;
FIG. 6 is a schematic of an edge-triggered annihilation based logic gate which implements a high fanin, N-input AND function;
FIG. 7 is a first graph of signal behavior within the FIG. 6 annihilation based logic gate, the stimulus for the signal behavior being 1) the rise and fall of clock signal CK, and 2) the logic block evaluating true;
FIG. 8 is a second graph of signal behavior within the FIG. 6 annihilation based logic gate, the stimulus for the signal behavior being 1) the rise and fall of clock signal CK, and 2) the logic block evaluating false;
FIG. 9 is a block diagram of a self-timed annihilation based logic gate; and
FIG. 10 is a schematic of a self-timed annihilation based logic gate which implements an 8-bit bypass comparator.

**Description of the Preferred Embodiment**

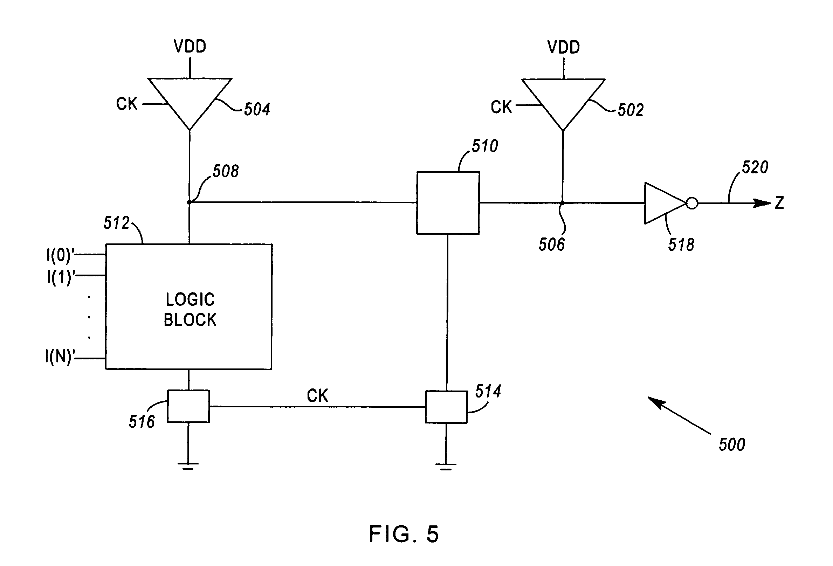

FIG. 5 illustrates a first preferred embodiment of a dynamic logic circuit 500 constructed in accordance with this description. The circuit 500 is ideal for implementing high fanin logic functions such as logical ANDs and compares. The circuit generally comprises means 502, 504 for precharging first 506 and second 508 nodes, means 510 for discharging the first node 506 during an evaluation phase of the dynamic logic circuit 500, and means 512 for evaluating a logic function. The means 510 for discharging the first node 506 and the means 512 for evaluating the logic function are configured so as to perform their discharge and evaluate functions substantially simultaneously. Further, the means 510 for discharging the first node 506 is responsive to a logic state of the second node 508, such that discharging of the first node 506 is halted upon discharge of the second node 508. The second node 508 is discharged by the means 512 for evaluating the logic function, but only if the logic function is evaluated to be true.

Having generally described a dynamic logic circuit 500 for implementing high fanin logic functions, the circuit 500, and variations thereof, will now be described in greater detail.

As used in this disclosure, the term "coupled" means a connection between two or more elements via wires and/or other elements. Thus, a statement that element A is coupled to element B encompasses both a direct connection between elements A and B, and a connection between elements A and B via other elements (e.g., through a resistor).

1. Edge-Triggered Annihilation Based Logic Gate

A. Generic Edge-Triggered Annihilation Based Logic Gate

The circuit 500 of FIG. 5 comprises first and second nodes 506, 508 which are alternately precharged and evaluated. Precharging occurs via dual precharging means 502, 504 which are respectively coupled to the first 506 and second 508 nodes. For example, if each of the precharging means 502, 504 (or "arming mechanisms") is driven by a periodic clock CK which alternately cycles high and low, the nodes 506, 508 might be precharged during low periods of the clock, and evaluated during high periods of the clock. During the low periods of the clock, each node 506, 508 is pulled to voltage VDD. During the high periods of the clock, evaluation of each node 506, 508 is made possible due to the periodic clock's disablement of the precharging means 502, 504.

The precharging means 502, 504 serve to "arm" or "reset" the FIG. 5 circuit 500. Each precharging means 502, 504 is essentially a switch which, in response to clock CK, selectively imposes a voltage defining a first logic state (e.g., VDD) on the node 506, 508 to which it is attached. As known in the art, any type of switching element or buffer for selectively imposing a voltage on a node may be used to construct the precharging means 502, 504. Furthermore, if the logic of the system is based upon current levels, rather than voltage levels, then each of the precharging means 502, 504 may comprise a switchable current source, the construction of which is also well known in the art. Any mechanism which serves the described switching function of the illustrated precharging means 502, 504 is intended to be incorporated herein.

The means 510 for discharging the first node 506 (also referred to herein as a "discharger") is coupled between the first 506 and second 508 nodes, and optionally receives an enable signal from a discharge enable circuit 514. In the FIG. 5 embodiment, the discharger 510 would be coupled to ground in the absence of discharge enable circuit 514.

The means 512 for evaluating a logic function is coupled between the second node 508 and a logic enable circuit 516 (or in the absence of a logic enable circuit 516, between the second node 508 and ground).

Together, the discharge enable circuit 514 and the logic enable circuit 516 may sometimes be referred to herein as "a circuit for enabling the means 510 for discharging the first node 506 and the means 512 for evaluating a logic function." Those skilled in the art will recognize that the discharge enable circuit 514 and the logic enable circuit 516 essentially serve as switches to respectively turn ON/OFF the means 510 for discharging the first node 506 and the means 512 for evaluating a logic function. In FIG. 5, each of these switches is driven by clock CK. Any mechanism which would provide these switching functions is intended to be incorporated herein.

When the FIG. 5 circuit 500 is used to implement a high fanin logical AND or compare, the means 512 for evaluating a logic function (also referred to as a logic block 512) is constructed so as to evaluate the complement of the high fanin function. For example, to evaluate the function:

$$Z = I(0) \cdot I(1) \cdots I(N),$$

where "·" indicates a logical AND operation, the means 512 for evaluating a logic function receives inputs I(0)', I(1)',... I(N)' and evaluates the function:

$$Z' = I(0)' + I(1)' + . . . I(N)',$$

where "+" indicates a logical OR operation, and I(N)' is the complement (or inverse) of I(N). This complementary OR function can be evaluated much faster than a high fanin AND, and reduces loading on node 508. If the means 512 for evaluating a logic function pulls the second node 508 low (i.e., to a logic "0" or ground) as a result of the complementary function evaluating "true", the discharge of the first node 506 is halted (or annihilated) so that the circuit 500 produces a logic high (or true signal) at output Z 520. Likewise, if the means 512 for evaluating a logic function maintains the second node 508 at its high (precharged) state as a result of the complementary function evaluating "false", the discharge of the first node 506 is allowed to ocntinue, thereby producing a logic low (or false indication) at output Z 520.

Finally, the FIG. 5 circuit 500 includes an inverter 518 coupled between the first node 506 and circuit output Z 520. Output signal Z 520 carries the state of an evaluated logic function of inputs I(0), I(1),...,I(N).

In operation, arming mechanism 502 resets node 506 to a defined logic state by imposing a voltage (e.g., VDD) on the node 506 upon excitation by a clock signal (e.g., CK). In the preferred embodiment, node 506 is precharged to a logic high state. Simultaneously (or at least substantially so), arming mechanism 504 resets node 508 to a defined logic state by imposing a voltage on the node 508 upon excitation by clock CK. In the preferred embodiment, node 508 is also precharged to a logic high state. The precharged state of node 506 causes a low output signal Z (synonymous with a logic low state) to be output from inverter 518.

Once nodes 506 and 508 are precharged, an enabling event (e.g., a rising or falling edge of clock signal CK) occurs which causes two substantially simultaneous events to occur. First, the arming mechanism 502 turns off and the discharger 510 begins to discharge node 506. In the preferred circuit embodiment shown in FIG. 5, the discharge of node 506 is also responsive to an enable signal received from a discharge enable circuit 514. The discharge enable circuit 510 may be driven by the same clock, CK, which controls arming mechanisms 502 and 504. Second, the arming mechanism 504 turns off and logic block 512 is evaluated. In the preferred embodiment shown in FIG. 5, the evaluation of logic block 512 is also responsive to an enable signal received from a logic enable circuit 516. The enable circuit 516 serves as a bridge between logic block 512 and ground and may also be driven by clock CK. In the absence of an enable circuit 516, logic block 512 could be coupled to ground.

Without arming mechanism 504 driving node 508 high, node 508 will take on a voltage level reflecting the evaluation of logic block 512. If the complementary logic function evaluated by logic block 512 evaluates true, node 508 will be pulled to ground. Otherwise, node 508 will remain high.

If node 508 is pulled low, the discharge of node 506 will be annihilated. That is, if node 508 is pulled low, discharger 510 will recharge node 506 so that output Z is pulled low. If node 508 remains in a precharged state (due to the logic of block 512 evaluating false), discharger 510 will continue to discharge node 506 until output Z is pulled high.

When designing a specific implementation of circuit 500, care should be taken to insure that 1) logic block 512 evaluates, 2) node 508 is pulled low (if applicable), and 3) the discharge of node 506 is halted (if applicable), prior to node 506 being discharged beyond the trigger point of inverter 518. In this manner, output Z remains monotonic.

### B. Edge-Triggered Annihilation Based AND Gate

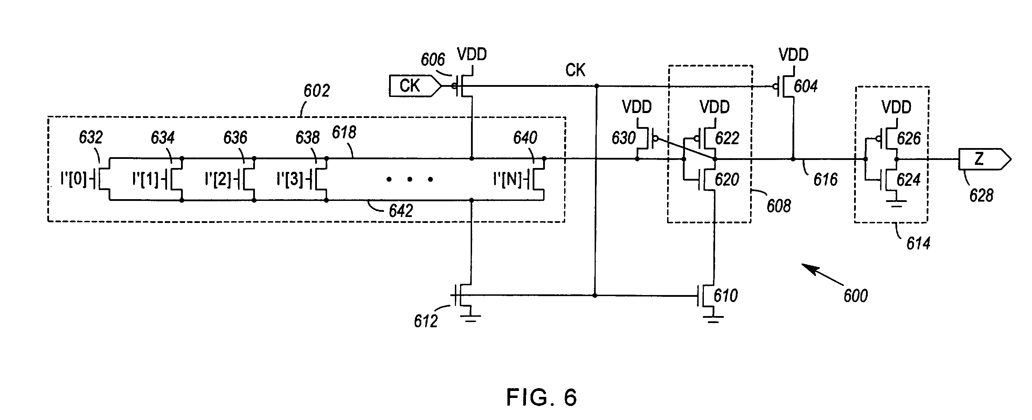

FIG. 6 is a schematic of an exemplary annihilation based logic gate 600 (a class of edge-triggered logic gate) for implementing a general function of interest (the complement of the general function of interest being evaluated by logic block 602). As shown in FIG. 6, the annihilation based logic gate 600 comprises first 604 and second 606 arming mechanisms, a discharger 608, a logic block 602, means 610, 612 for enabling the discharger 608 and the logic block 602, and an inverter 614. Each arming mechanism 604, 606 comprises a PFET, respectively coupled between VDD and a node 616, 618 to be precharged. The means 610 for enabling the discharger 608 and the means 612 for enabling the logic block 602 each comprise an NFET coupled between the device it is enabling and ground. Both the arming mechanisms 604, 606 and the enabling means 610, 612 are controlled by a common clock, CK. In the FIG. 6 circuit embodiment, clock signal CK is presumed to be low during a precharge phase of the clock, and high during an evaluate phase of the clock. During a precharge phase of clock CK, enabling means 610 and 612 serve to isolate the discharger 608 and logic block 602 from ground, thereby preventing early discharge and/or evaluation of nodes 616 and 618.

The discharger 608 of FIG. 6 is essentially an inverter comprising an NFET 620 and a PFET 622. The NFET 620 is coupled between node 616 and the discharge enabler 610, and the PFET 622 is coupled between node 616 and VDD. Each of these FETS 620, 622 receives the voltage of node 618 at its gate. Optionally, a means 630 to compensate for charge sharing between nodes 616 and 618 may be interconnected in parallel with the discharger 608. In FIG. 6, this device 630 is a PFET coupled between node 618 and VDD, which receives the voltage on node 616 at its gate. Whenever node 616 is being pulled low, some amount of charge will be drained from node 618 through NFET 620. This causes node 618 to droop, which slows down the circuit 600. PFET 630 therefore turns on when node 616 goes low, thereby driving node 618 high and eliminating drooping of node 618.

The inverter 614 comprises an additional NFET 624 and PFET 626. The NFET 624 is coupled between circuit output Z 628 and ground, and the PFET 626 is coupled between output Z 628 and VDD. Each of these FETS 624, 626 receives the voltage of node 616 at its gate.

By way of example, the annihilation based logic gate 600 of FIG. 6 has been configured to implement a high fanin, N-input AND function. As shown in FIG. 6, logic block 602 therefore evaluates the complement function of an N-input AND function (i.e., an N-input OR function) and receives inverse inputs I(0)',I(1)',..,I(N)'. The logic block 602 implements the N-input OR function utilizing NFETS 632-640, each of which have their source and drain respectively coupled to nodes 618 and 642. Each inverse input I(0)',I(1)',..,I(N)' is input to the gate of a respective NFET 632-640.

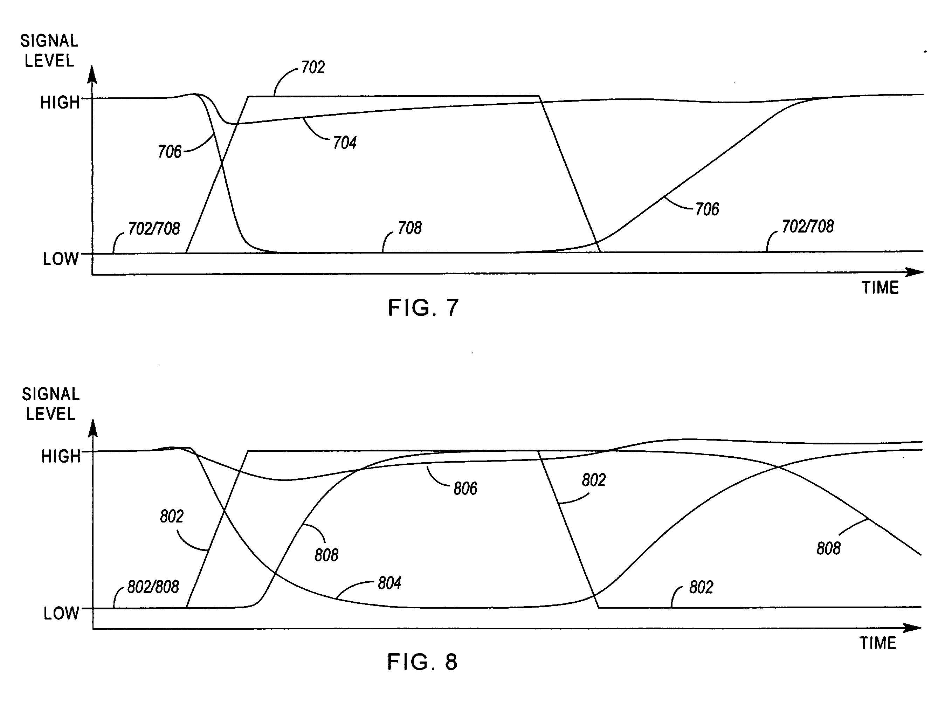

In operation, nodes 616 and 618 are precharged high by respective arming mechanisms 604 and 606. Then, upon receipt of an enabling event (e.g., a rising edge of clock signal CK), the arming mechanisms 604 and 606 are turned off, and substantially simultaneously 1) discharger 608 is enabled to begin discharging node 616 while 2) logic block 602 is enabled to evaluate. If, at the time of the enabling event, any of NFETs 632-640 are on (or are subsequently turned on), an electrical connection is formed between nodes 642 and 618, and node 618 gets discharged, indicating that the complement function (OR) is logically true. The discharge of node 618 causes the PFET 622 of the discharger 608 to turn on and drive node 616 high. Thus, the discharge of node 616 gets annihilated before it hits the trigger point of inverter 614. Accordingly, the output signal Z 628 remains false, which indicates that an AND of inputs I(0),I(1),..,I(N) evaluated to a logic "0", or false state. FIG. 7 is a timing diagram illustrating a signal comparison in this scenario. Signals CK 702, the respective values 704, 706 of nodes 616 and 618, and the resulting output signal Z 708 are shown for comparison.

If, on receipt of the enabling event, none of NFETs 632-640 are on, no electrical connection is formed between nodes 642 and 618. Accordingly, node 618 does not get discharged, which indicates that the complement function (OR) is logically true. Since node 618 remains high, PFET 622 remains off, NFET 620 remains on, and node 616 continues to discharge past the trigger point of inverter 614. Accordingly, the output signal 628 is pulled from low to high, which indicates that an AND of I(0),I(1),..,I(N) evaluated to a logical "1", or true state. FIG. 8 is a timing diagram illustrating a signal comparison in this scenario. Again, signals CK 802, the respective values 804, 806 of nodes 616 and 618, and the resulting output signal Z 808 are shown for comparison.

In the preferred embodiment, inverse inputs I(0)'...I(N)' are stabilized during, and prior to the end of, the precharge phase of clock CK. Stable signals during the setup time prior to the rising clock signal edge is required in the preferred embodiment because the logic gate 500 is edge-triggered. In this edge-triggered gate, all activity occurs on the rising edge of the clock signal. During the rest of the evaluate phase, the value of output Z 520 is held.

To avoid a race between discharger 608 and logic block 602, the annihilation based logic gate 600 of FIG. 6 must be properly timed. During the precharge phase of clock CK, inputs I'[0]...I'[N] will preferably have stabilized, and NFETS 620 and 624 will be turned on (when NFET 624 is turned on, it pulls output Z 628 low). Though logic block 602 and discharger 608 are "set up" during the precharge phase of clock CK, neither will conduct current and perform their associated functions due to the low signal provided to the gates of enablement means 610 and 612. However, when clock CK transitions high, logic block 602 and discharger 608 will be enabled substantially simultaneously, and a race is possible as discharger 608 attempts to discharge node 616 past the trigger point of inverter 614 prior to logic block 602 pulling node 618 low (assuming that logic block 602 will evaluate true).

It will be appreciated from the above discussion that the rate of discharge of node 618 and the speed at which the discharge on node 616 can be annihilated if node 618 begins to discharge is critical. Accordingly, it is preferable to control discharge and annihilation timing through the sizing of appropriate FETS. Of critical importance is the sizing of NFET 620, which controls how fast node 616 discharges, and PFET 622, which determines how quickly the discharge of node 616 is canceled. The rate of discharge on node 616 may be further controlled by adjusting the trigger point of inverter 614 via the size ratio between PFET 626 and NFET 624. The sizing of the FETS may be ratioed to ensure that node 618 discharges faster than node 616. As will be obvious to those skilled in the art, the sizing of FETS may vary depending upon the kind of function implemented by logic block 602, the amount of delay required in discharger 608, the desired cancellation switching time, and the desired trigger point for inverter 614.

## 2. Self-Timed Annihilation Based Logic Gate

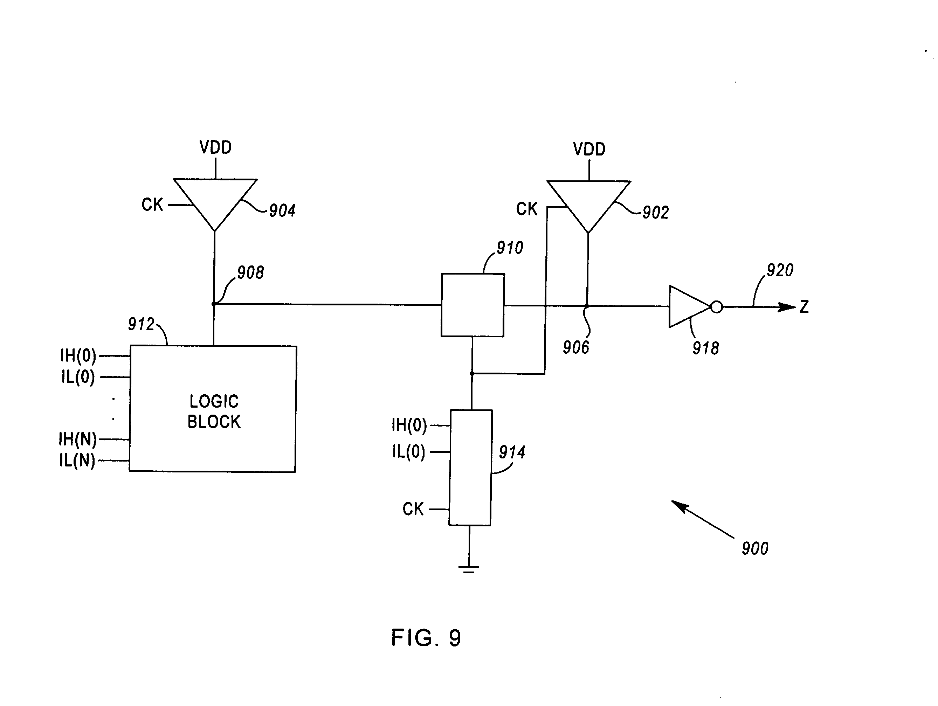

As previously mentioned, an annihilation based logic gate may also be implemented as a self-timed logic gate 900 (FIG. 9). The operation of a self-timed gate 900 is similar to that of an edge-triggered gate 600, but for the enabling event of the circuit 900 being the receipt of valid data. In a self-timed annihilation based logic gate 900, the discharger 910 does not begin to discharge node 906 until the inputs to logic block 912 are known to be valid, and likewise, node 908 cannot discharge prior to the receipt of valid data.

FIG. 9 is a block diagram of a self-timed logic gate 900 which utilizes vector logic to achieve its self timing. In order to provide a better explanation of the operation of a self-timed annihilation based logic gate, a brief discussion of vector logic is first provided below. For a more detailed description of vector logic and mousetrap logic gates, see U.S. Patent #5,389,835 to Yetter, which is hereby incorporated by reference for all that it discloses.

## A. Vector Logic

A vector logic variable V is defined as a set of i vector logic states encoded on a set of n logic paths. Each of the n logic paths is referred to hereinafter as a vector component of V. At any given time, each vector component may assume one of two values: "active" or "inactive".

The encoding of i vector logic states onto the vector logic variable V is performed in such a way as to allow the implementation of self-timed logic gates. Each vector logic variable V is encoded with the following properties:

(a) At least one "invalid" state must exist. One invalid state is the vector logic state wherein all vector components of vector logic variable V are inactive. More than one invalid state may exist.
(b) i "valid" logic states are defined by a subset of m active vector components and (n-m) inactive vector components.
(c) The transition from any invalid state to any valid state must avoid a transition through any other valid state.

Encodings which obey the foregoing rules always leave one or more combinations which are neither valid nor invalid. These combinations are referred to as "illegal" states.

A system which utilizes vector logic will allow transitions from an invalid state to a valid state, and vice versa, but will not allow transitions to an illegal state, or transitions between valid states.

In the vector notation used throughout this document, vector variables are denoted in bold print, vector components are enclosed within angle brackets "< >", a "0" or "logic low" denotes an inactive vector component, and a "1" or "logic high" denotes an active vector component.

As a first example of vector logic, consider a vector logic variable V having two vector components (n=2) and two valid vector logic states (i=2), wherein each valid state is defined by one active vector component (m=1). TABLE 1 illustrates the encoding of such a vector logic:

TABLE 1

| V | Vector Logic State |
|---|---|
| <0,0> | Invalid |
| <0,1> | V = 0 (valid state) |
| <1,0> | V = 1 (valid state) |
| <1,1> | Illegal |

As a second example of vector logic, consider a vector logic variable V having three vector components (n=3) and three valid vector logic states (i=3), wherein each valid state is again defined by one active vector component (m=1). TABLE 2 illustrates an encoding of this second example of vector logic:

TABLE 2

| V | Vector Logic State |
|---|---|
| <0,0,0> | Invalid |
| <0,0,1> | V = 0 (valid state) |
| <0,1,0> | V = 1 (valid state) |
| <1,0,0> | V = 2 (valid state) |
| <1,1,1> | Illegal |
| <1,1,0> | Illegal |
| <1,0,1> | Illegal |
| <0,1,1> | Illegal |

The number of possible vector logic states for a logic network can be conceptually generalized by the following mathematical combinatorial formula (n things taken m at a time), where n is the set of vector components (also logic paths) which defines each vector logic variable, m is the subset of logic paths which must be active (logic high) to specify a valid vector logic state, and i is the number of possible vector logic states given m and n:

$$i = \binom{n}{m} = \frac{n!}{m!(n-m)!}$$

B. Generic Self-Timed Annihilation Based Logic Gate

A generic self-timed annihilation based logic gate is illustrated in FIG. 9. The gate 900 is similar to an edge-triggered annihilation based logic gate 500 in that it comprises first 906 and second 908 precharged nodes which are cyclically precharged and evaluated under the control of respective arming mechanisms 902, 904. The gate 900 also comprises a discharger 910, a logic block 912, an inverter 918, and at least one circuit output Z 920. The circuit differs from an edge-triggered gate implementation 500 in that logic block 912 may be connected directly to ground, and discharger 910 is coupled to ground through an enablement means 914 which receives clock CK and at least one vector input (e.g., **I(0) = <IH(0),IL(0)>**).

In operation, nodes 906 and 908 of gate 900 are precharged to a high logic level during the low phase of clock CK. Preferably, vector logic inputs **I(0)...I(N)** are received and become stable prior to clock CK transitioning high. If so, gate 900 functions in a similar fashion to gate 500. However, should the generation of inputs **I(0)...I(N)** be delayed by an upstream logic phase, gate 900 will not evaluate upon clock CK's transition from low to high. Rather, enablement means 914 will prevent discharger 910 from discharging node 906 until such time that vector logic input **I(0)** transitions to a valid state. At that point, discharger 910 will be enabled, and substantially simultaneously, logic block 912 will evaluate. To prevent a race condition, the vector logic input received by enablement means 914 should be the vector input associated with the greatest propagation delay. Otherwise, a scenario could arise wherein discharger 910 discharges node 906 past the trigger point of inverter 918, prior to logic block 912 receiving all inputs which can affect the evaluation of node 908. If the vector input associated with the greatest propagation delay is not known, additional vector inputs can be input to enablement means 914.

C. Self-Timed Annihilation Based Comparator

In a comparator function, two values are compared bit by bit to determine if they are equal. Accordingly, a logical exclusive OR function must be performed on each like bit in each of n words. Table 3 illustrates the truth table of a 1-bit comparator based on Boolean logic.

TABLE 3

| A[0] | B[0] | $Z = (A \oplus B)'$ |
|------|------|---------------------|
| 0 | 0 | 1 |
| 0 | 1 | 0 |
| 1 | 0 | 0 |
| 1 | 1 | 1 |

In Boolean logic, a 1-bit comparator may be described by the logic equation:

$$Z = A[0] \cdot B[0] + A[0]' \cdot B[0]'$$

For an N-bit comparator, a logical exclusive OR function must be performed between two values A and B on a bit-by-bit basis, and each logical exclusive OR evaluation must evaluate to true (i.e., the outputs of each exclusive OR evaluation must be fed through a logical AND function). Accordingly, in Boolean logic, an N-bit comparator may be described by the logic equation:

$$Z = (A[0] \cdot B[0] + A[0]' \cdot B[0]') \cdot (A[1] \cdot B[1] +$$

$$A[1]' \cdot B[1]') \cdot ... \cdot (A[N] \cdot B[N] + A[N]' \cdot B[N]')$$

It is clear that the logic of an N-bit comparator requires an N-bit AND evaluation. Accordingly, the present invention may be employed to drastically reduce the time it takes to perform the comparator function by computing the inverse of the logical AND function, which is a much faster logical OR type function, as described in FIG. 5.

Table 4 illustrates a truth table of a 1-bit comparator based on vector logic with two valid states (where "inv" refers to the invalid state, and "x" refers to a "don't care" state).

TABLE 4

| A | B | O | AH [0] | AL[0] | BH[0] | BL[0] | OH[0] | OL[0] |
|-----|-----|-----|--------|-------|-------|-------|-------|-------|
| inv | inv | inv | 0 | 0 | 0 | 0 | 0 | 0 |
| inv | x | inv | 0 | 0 | x | x | 0 | 0 |
| x | inv | inv | x | x | 0 | 0 | 0 | 0 |
| 0 | 0 | 1 | 0 | 1 | 0 | 1 | 1 | 0 |
| 0 | 1 | 0 | 0 | 1 | 1 | 0 | 0 | 1 |
| 1 | 0 | 0 | 1 | 0 | 0 | 1 | 0 | 1 |
| 1 | 1 | 1 | 1 | 0 | 1 | 0 | 1 | 0 |

As shown in Table 4, a logical exclusive OR function will only evaluate true when AH[0] and BH[0] are both high, or when AL[0] and BL[0] are both high. Any other combination of AH[0], AL[0], BH[0] and BL[0] will result in a false evaluation of the logical exclusive OR function.

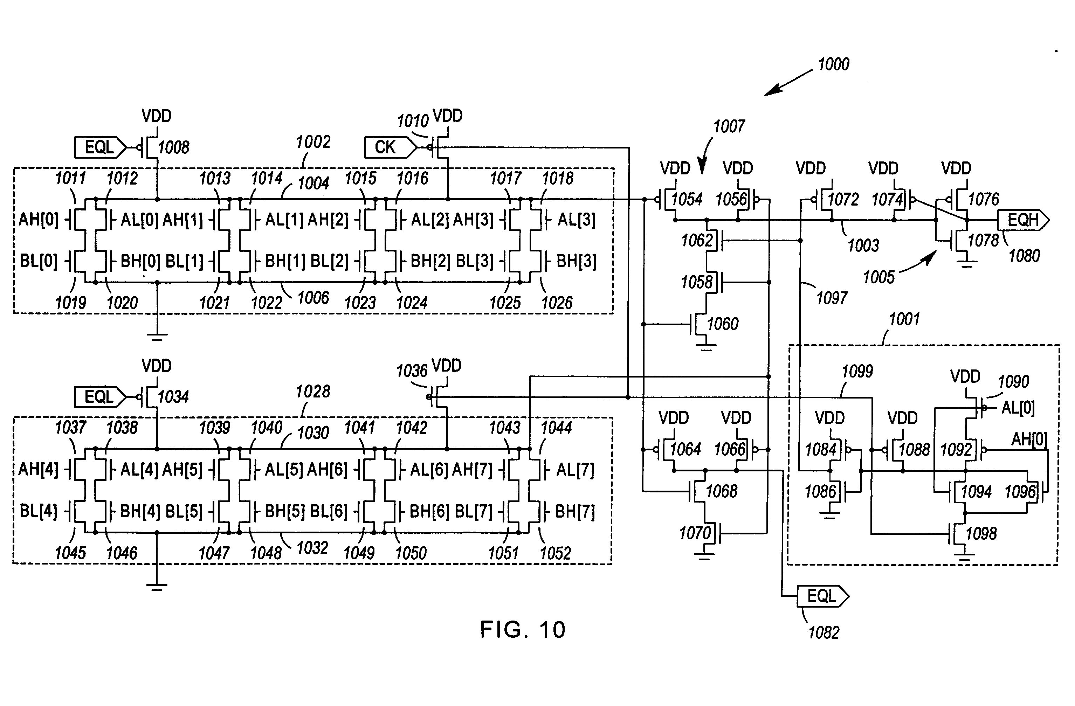

FIG. 10 is a schematic of a self-timed logic gate 1000 for implementing an 8-bit comparator function. To reduce loading on nodes 804 and 830, each of logic blocks 802 and 828 evaluates a 4-bit exclusive OR function, with the results of these exclusive ORs being combined in a NOR function. Due to the high fanin AND of a typical 8-bit comparator, one can appreciate that the FIG. 10 logic gate 1000 can evaluate exclusive ORs and NORs much faster than ANDs and XNORs (as is conventionally done in a dynamic logic system). For each bit to be compared, a logical AND function is performed on AH and BL, and also on AL and BH (i.e., an XOR function). The outputs of these XORs are then NORed together within each logic block 802, 828. Each logic block comprises sixteen NFETS 811-826, 837-852 coupled between a precharged node 804, 830 and ground 806, 832.

In operation, nodes 1003, 1004, and 1030 are precharged to a high logic state via respective arming mechanisms 1072, 1010, and 1036. Though any of these arming mechanisms 1003, 1004, 1030 may be responsive to clock signal CK 1099, it is also possible to use the output of enablement means 1001 as both an enable and precharge signal 1097. In the FIG. 10 embodiment, clock CK 1099 serves to control arming mechanisms 1010 and 1036, while combined precharge/enable signal 1097 serves to control arming mechanism 1072. Vector output **EQ** comprises high and low components (**EQ=<EQH,EQL>**). During the precharge phase of clock CK 1099, output EQ is driven to an invalid state (i.e., **<0,0>**). Component **EQH** 1080 is driven low through an inverter comprising FETS 1076 and 1078, and component **EQL** 1082 is driven low through a mousetrap AND gate comprising FETS 1064-1070. Optionally, nodes 1004 and 1030 can also be pulled high via feedback FETS 1008, 1034 driven by output **EQL** 1082.

The self-timed enablement means 1001 comprises clock 1099 and data inputs. In FIG. 10, the data input is a vector representation of the first bit of a quantity to be compared (i.e., **<AH[0],AL[0]>**). The components of the data input vector are received by the FETS 1090-1096 of a mousetrap OR gate and are ANDed with the clock input 1099 via NFET 1098. When clock CK 1099 is in its precharge phase, it drives PFET 1088 so as to pull the input to an inverter comprising FETS 1084 and 1086 high, thus driving arming mechanism 1072 to pull node 1003 high. When clock CK 1099 transitions high, arming mechanism 1072 continues to pull node 1003 high, and prevents decay of the node's precharged state until such time that data input **A[0]** becomes valid. At the same time, enablement means 1001 also prevents the discharger (FETS 1054-1060) from discharging the voltage on node 1003 by failing to apply an enable signal 1097 to NFET 1062.

Upon receipt of valid data, logic blocks 1002 and 1028 evaluate the state of FETS 1011-1026 and 1037-1052, and upon a mismatch of any components of inputs **A** and **B**, the discharge of node 1003 is cancelled, node 1003 is pulled high, and output component **EQL** is pulled high. The state of output **EQ** 1080, 1082 will then be **<0,1>**. If a comparison of **A** and **B** through logic blocks 1002 and 1028 results in a determination that **A** and **B** are equal, then node 1003 is discharged (via FETS 10558-1062) past the trigger point of the inverter comprising FETS 1076 and 1078, and output **EQ** 1080, 1082 transitions to **<1,0>**.

Note that a feedback loop comprising PFET 1074 may be provided to stabilize the output 1080.

Also note that in the absence of loading on nodes 1004 and 1030, logic blocks 1002 and 1028 could be combined to evaluate a single logic function, and various simplifications of the FIG. 10 circuit 1000 would result.

While illustrative and presently preferred embodiments of the invention have been described in detail herein, it is to be understood that the inventive concepts may be otherwise variously embodied and employed, and that the appended claims are intended to be construed to include such variations, except as limited by the prior art.

**Claims**

1. A dynamic logic circuit (500), comprising:

   a) means (502, 504) for precharging first (506) and second (508) nodes;
   b) means (510), responsive to the second node, for discharging the first node during an evaluation phase of the dynamic logic circuit; and
   c) means (512) for evaluating a logic function;

   wherein said means for discharging the first node and said means for evaluating the logic function are configured so as to perform their functions substantially simultaneously;
   wherein the means for evaluating the logic function discharges the second node if the logic function is evaluated as true; and
   wherein the discharging of the first node is halted upon discharge of the second node.

2. A dynamic logic circuit (500) as in claim 1, wherein said means (510) for discharging the first node (506) and said means (512) for evaluating the logic function are timed so as to prevent a change in the logic state of the first node prior to the logic function being evaluated.

3. A dynamic logic circuit (500) as in claim 1, wherein a common clock edge ensures that said means (510) for discharging the first node (506) and said means (512) for evaluating the logic function perform their functions substantially simultaneously.

4. A dynamic logic circuit (900) as in claim 1, wherein a common clock edge and valid data ensures that said means (910) for discharging the first node (906) and said means (912) for evaluating the logic function perform their functions substantially simultaneously.

5. A dynamic logic circuit (900) as in claim 4, wherein the valid data is self-timed vector data.

6. A dynamic logic circuit (1000) as in claim 4, wherein the common clock edge and valid data is received by both:

   a) a circuit (1062) for enabling the means (1054, 1056, 1058, 1060) for discharging the first node (1003); and
   b) the means (1072) for precharging the first node.

7. A dynamic logic circuit (500) as in claim 1, wherein the means (510) for discharging the first node (506) halts the discharge of the first node upon discharge of the second node (508).

8. A dynamic logic circuit (500) as in claim 7, wherein the means (510) for discharging the first node (506) not only halts the discharge of the first node upon discharge of the second node (508), but also reverses the discharge of the first node upon discharge of the second node.

9. A dynamic logic circuit (500) for converting an OR function output (508) to its monotonic AND equivalent, comprising:

   a) a discharge circuit (510) coupled between first (506) and second (508) periodically precharged nodes, wherein the discharge circuit is configured to:

      i) begin discharging the first periodically precharged node during an evaluate phase of said first and second periodically precharged nodes; and
      ii) charge the first periodically prechared node upon discharge of the second periodically precharged node; and

   b) an inverter (518) having its input connected to the first periodically precharged node.

10. A method for fast evaluation of high fanin logic functions, said method comprising the steps of:

    a) precharging first (506) and second (508) nodes;
    b) substantially simultaneously,

       i) discharging the first node; and
       ii) evaluating a logic block (512) producing an output on the second node;

    c) if the second node is discharged after evaluation of the logic block, canceling discharge of the first node; and
    d) if the second node remains precharged after evaluation of the logic block, allowing discharge of the first node to continue.

PRIOR ART

FIG. 1

PRIOR ART

FIG. 2

PRIOR ART

FIG. 3

400

VDD

CK

I(0)  I(1)  I(2)  I(3)

402  404  406  408  410  412

414  VDD

CK

I(4)  I(5)  I(6)

416  418  420  422  424

426

VDD

CK

428  430  432  434

CK

436

438

Z

*PRIOR ART*

FIG. 4

FIG. 5

FIG. 6

FIG. 7

FIG. 8

FIG. 9

FIG. 10

EP 0 929 154 A1

European Patent
Office

**EUROPEAN SEARCH REPORT**

Application Number

EP 99 30 0118

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US 5 291 076 A (BRIDGES JEFFREY T ET AL) 1 March 1994 * column 6, line 9 - column 8, line 68; figures 3-5 * | 1-3,7,10 | H03K19/096 H03K19/017 |
| X | US 4 401 903 A (IIZUKA TETSUYA) 30 August 1983 * column 4, line 5 - column 5, line 29; figures 2,3 * | 1-3,7,10 | |

TECHNICAL FIELDS
SEARCHED     (Int.Cl.6)

H03K

The present search report has been drawn up for all claims

| Place of search | Date of completion of the search | Examiner |
|---|---|---|
| THE HAGUE | 21 April 1999 | Feuer, F |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## ANNEX TO THE EUROPEAN SEARCH REPORT
## ON EUROPEAN PATENT APPLICATION NO.

EP 99 30 0118

This annex lists the patent family members relating to the patent documents cited in the above-mentioned European search report.
The members are as contained in the European Patent Office EDP file on
The European Patent Office is in no way liable for these particulars which are merely given for the purpose of information.

21-04-1999

| Patent document cited in search report | | Publication date | Patent family member(s) | | Publication date |
|---|---|---|---|---|---|
| US 5291076 | A | 01-03-1994 | NONE | | |
| US 4401903 | A | 30-08-1983 | JP | 56041580 A | 18-04-1981 |

For more details about this annex : see Official Journal of the European Patent Office, No. 12/82

EPO FORM P0459